# EUROPEAN PATENT SPECIFICATION

(11) **EP 1 633 020 B1**
(45) Date of publication and mention of the grant of the patent: **11.03.2009**
(21) Application number: 04257983.9
(22) Date of filing: 21.12.2004
(51) Int. Cl.: H01R 13/52

(54) **Waterproof audio player**
Wasserdichtes Audiospielgerät
Dispositif audio étanche à l'eau

(30) Priority: 07.09.2004 US 934744
(43) Date of publication of application: 08.03.2006
(73) Proprietor: IDT Data System Limited, Kowloon, Hong Kong (CN)
(72) Inventor: Chan, Raymond 9th Floor, Block C, Phase 1, Hunghom, Kowloon, Hong Kong (CN)
(74) Representative: Martin, David John

(56) References cited:
- US-A1- 2004 120 219

## Description

The invention relates to an audio player and particularly but not exclusively to an MP3 player with FM radio, which is waterproof or splash-proof.

### BACKGROUND OF THE INVENTION

Audio players that are waterproof or splash-proof are not new, which normally utilize earphones instead of built-in speakers for audio output as speakers are vulnerable to damage by water and/or are difficult to protect. Such earphones are usually permanently wired to avoid a loose connection that is leakage-prone and this hampers output flexibility.

US 2004/120219 discloses an apparatus for housing an audio system in an aquatic environment, said apparatus particularly of use under hydrostatic pressure.

The invention seeks to obviate or at least alleviate such a shortcoming by providing a new or improved waterproof audio player.

### SUMMARY OF THE INVENTION

According to the invention, there is provided a waterproof audio player according to claim 1.

Preferably, at least one of the casing and the lid includes resilient material around its inner wall for sealing engagement with the inner wall of the other of the casing and the lid.

It is preferred that the earphone includes an electric cable connected to the plug and extending out from inside the lid, with a seal provided between the cable and the lid.

It is further preferred that the seal comprises glue.

Preferably, the electrical plug includes a base having a first end from which the electrical connector projects through the inner wall of the lid and an opposite second end located by an internal fixture of the lid.

Preferably, the audio playing module includes an input port provided on the inner wall of the casing.

More preferably, the input port comprises a USB socket.

It is preferred that the lid is detachable from the casing.

As an example, the audio playing module comprises an MP3 playing module.

### BRIEF DESCRIPTION OF DRAWINGS

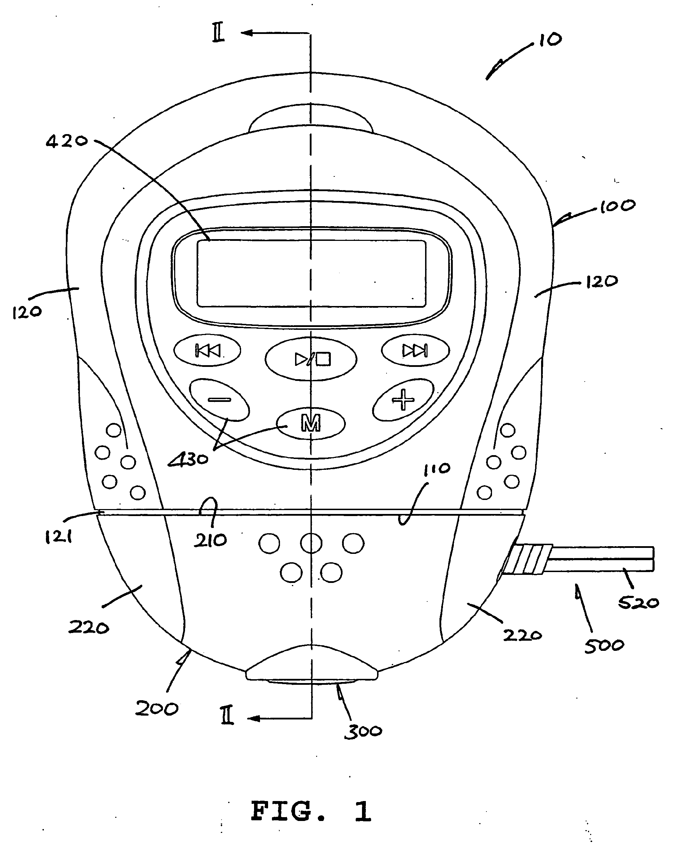

Figure 1 is a front view of an embodiment of an audio player in accordance with the invention;
Figure 2 is a cross-sectional right side view of the audio player of Figure 1, taken along line II-II;
Figure 3 is a left side view of the audio player of Figure 1;

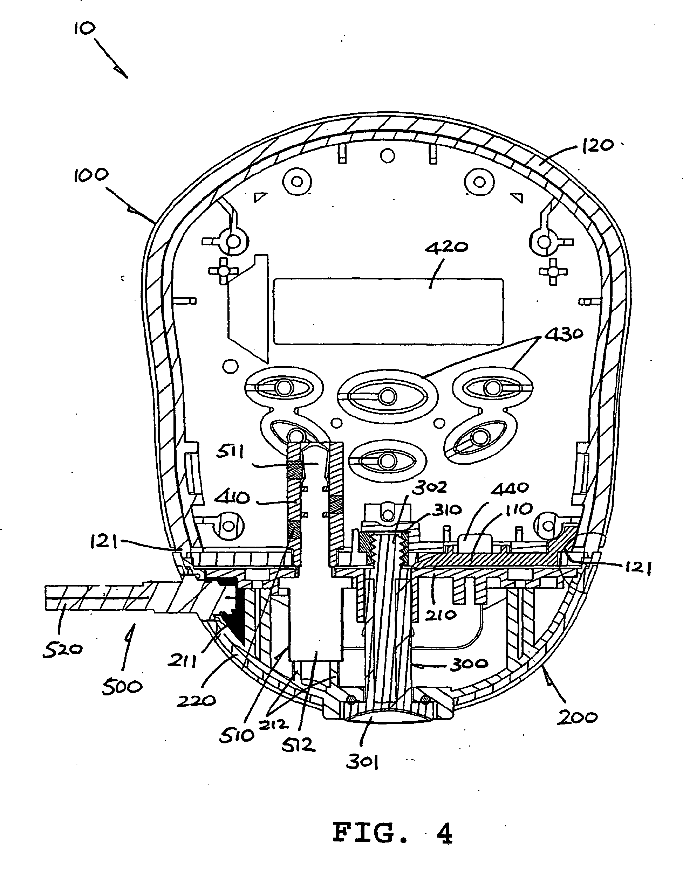

Figure 4 is a cross-sectional rear view of the audio player of Figure 3, taken along line IV-IV;

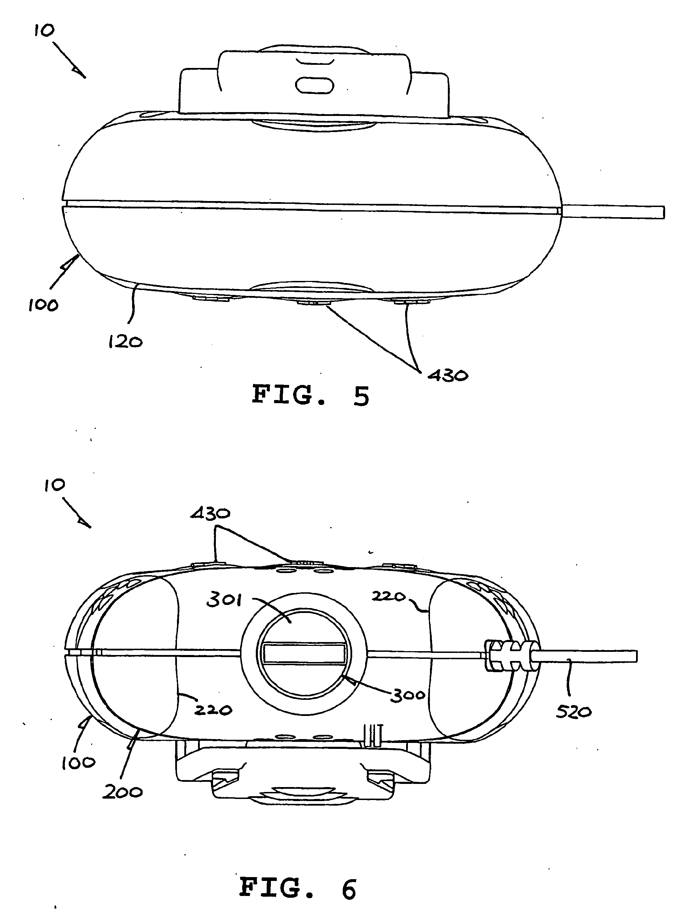

Figure 5 is a top plan view of the audio player of Figure 1;
Figure 6 is a bottom plan view of the audio player of Figure 1;

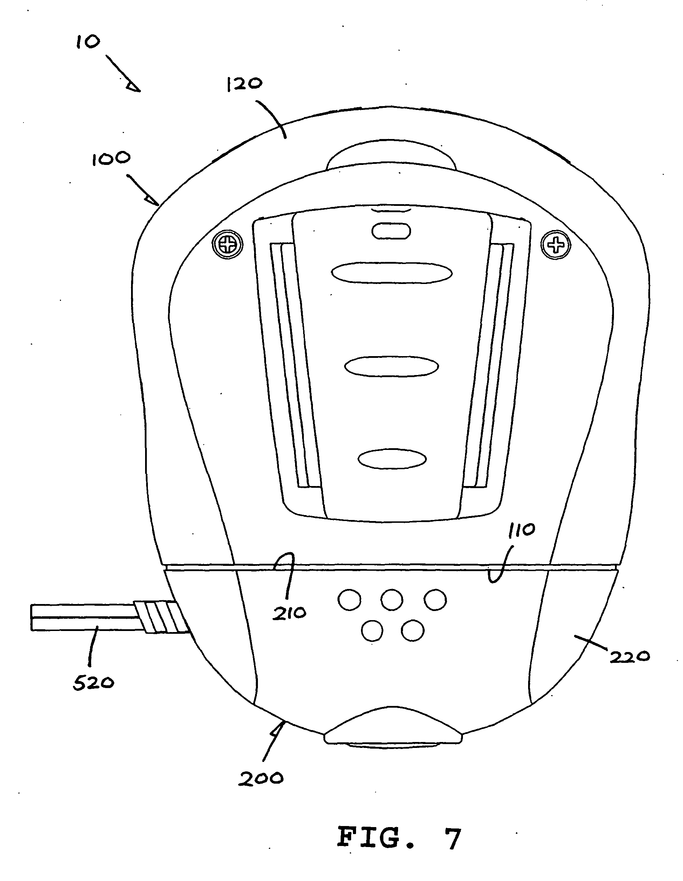

Figure 7 is a rear view of the audio player of Figure 1;

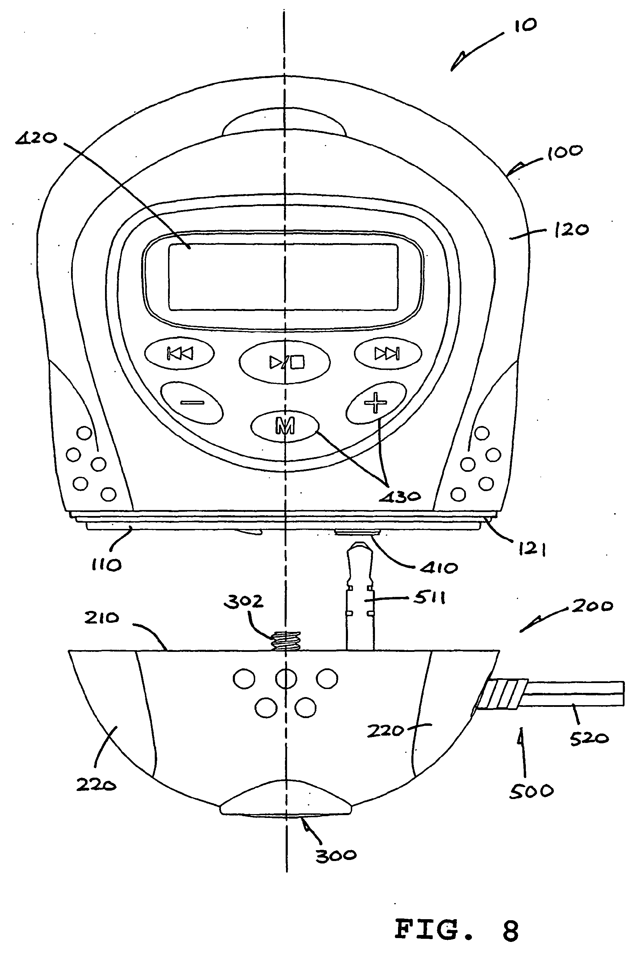

Figure 8 is a front view of the audio player of Figure 1, with two parts thereof shown separated; and

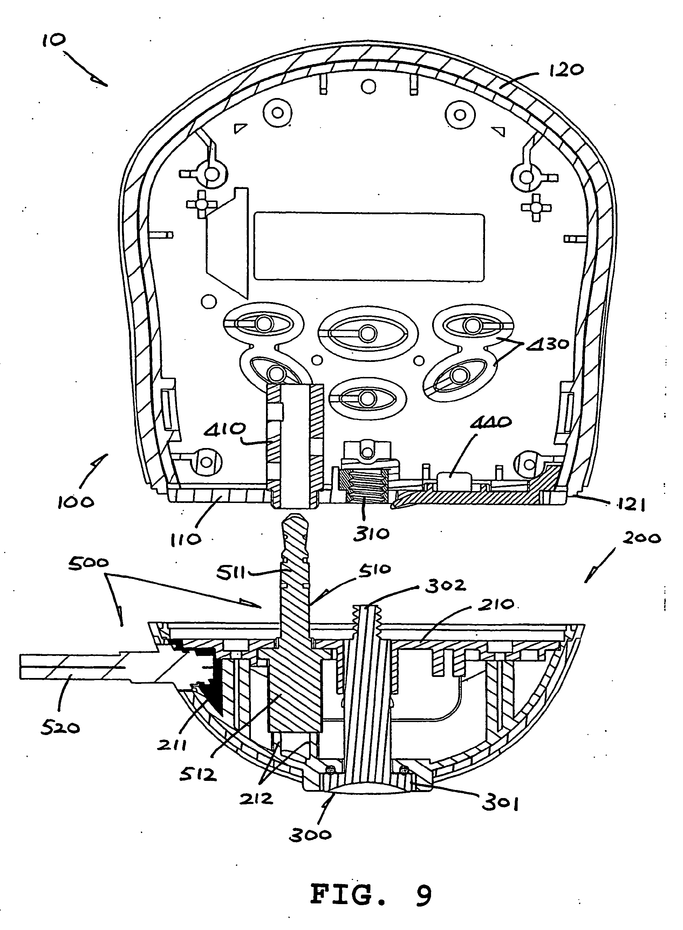

Figure 9 is a cross-sectional rear view of the audio player of Figure 8.

### DETAILED DESCRIPTION OF PREFERRED EMBODIMENT

Referring to the drawings, there is shown a waterproof audio player in the form of a portable MP3 player 10 embodying the invention, which has a flat oval body formed by a casing 100 and a separate bottom lid 200 closing the casing 100. The casing 100 and the lid 200 include, as between them, respective horizontal generally flat inner walls 110 and 210 confronting each other while the lid 200 closes the casing 100.

The casing 100, which is primarily molded from a hard plastics material, includes a relatively thick coating 120 of a resilient rubber material applied thereon by an insert molding operation for example. The coating 120 extends over the complete periphery of the casing 100 including a bottom portion 121 around its inner wall 110, which acts as a seal ring for sealing engagement with the inner wall 210 of the lid 200. Similarly, the lid 200 is molded from a hard plastics material and includes an insert molded coating 220 of the same rubber material on opposite left and right sides thereof matching the casing coating 120. Apart from providing the seal 121, the rubber coatings 120 and 220 serve to facilitate gripping of the MP3 player 10 by hand.

The lid 200 has a vertical central axis and incorporates an upright screw or bolt 300 which extends along the axis through the lid 200 from below, having a lower head 301 and an upper screw-threaded end 302. There is a nut 310 mounted centrally at the inner wall 110 of the casing 100 for engagement by the bolt 300. While closing the casing 100, the lid 200 is attached and secured in place upon tightening the bolt 300 through the nut 310, whereby the lid 200 is pressed against the casing 100 and the two parts are sealed together. The outer walls of the casing 100 and the lid 200 including all the features thereon are made watertight and this, in conjunction with the sealing engagement between the casing 100 and the lid 200, renders the overall MP3 player 10 at least splash-proof or in the case of the described embodiment waterproof to one meter depth of water.

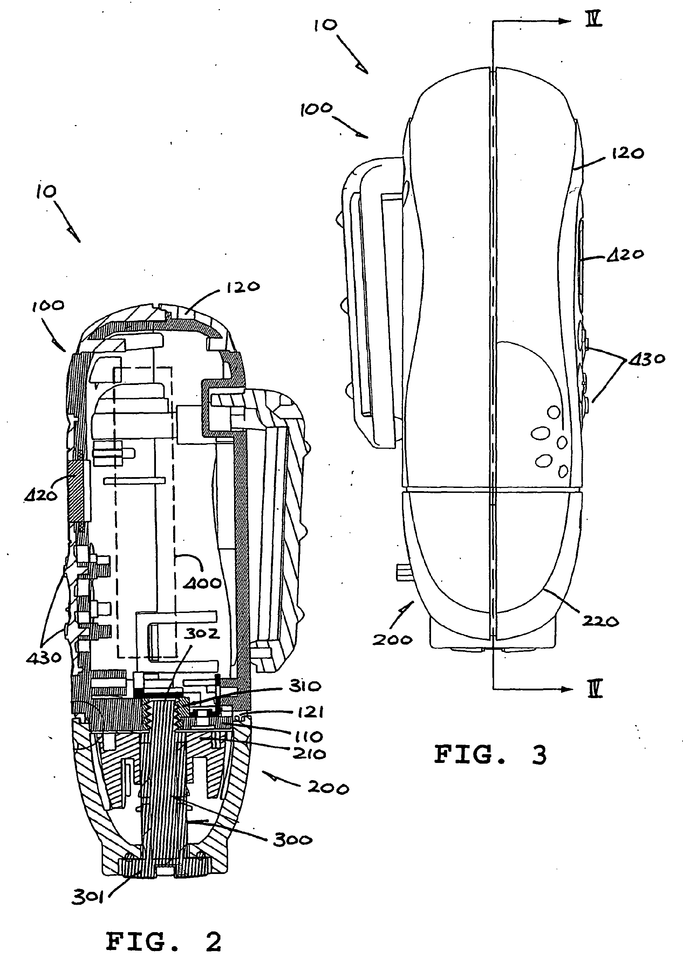

The casing 100 houses an MP3 playing module 400 (only schematically depicted in Figure 2) which includes a Ø3.5mm phone jack 410 mounted on the inner wall 110 adjacent the nut 310 for audio output. The playing module 400 is connected to an LCD display 420 and a number of press keys 430 on the front surface for operation. Also mounted on the inner wall 110 is a USB socket 440 on the other side of the nut 310 as an input port for loading MP3 data. There is further a built-in FM radio tuner. All these constitute a main unit of the MP3 player 10.

The MP3 player 10 incorporates an integrated earphone 500 which includes an electrical plug 510 fixed inside the lid 200. An electric cable 520 connected to the plug 510 leading to a pair of ear-mounted speakers (not shown) extends out from inside the lid 200, which is sealed at a position just before leaving the lid 200 by glue 211 against water ingress.

The plug 510 has a Ø3.5mm electrical connector 511 and a base 512 from an upper end of which the connector 511 extends co-axially upright. The base 512 is located wholly within a cavity of the lid 200, in that the cavity has a bottom defined by an internal fixture 212 which supports the lower end of the base 512. The connector 511 projects upwardly, at right angles, through the inner wall 210 of the lid 200. The plug 510 is positioned aligning with the phone jack 410 such that closing of the lid 200 upon the casing 100 brings about insertion of the connector 511 into the jack 410 whereby the earphone 500 is connected at the same time.

The lid 200 may be opened or detached by loosening the bolt 300. Removal of the lid 200 reveals the phone jack 410 on the casing 100, and this permits the use of another earphone or connection of the main unit to an amplifier or a pair of active speakers for example. The USB socket 440 is also revealed for loading of MP3 data. It is noted that the main unit can operate without the lid 200 and earphone 500.

## Claims

1. A waterproof audio player comprising:
a body having a casing (100) and a lid (200) closing the casing in a sealed manner, the casing and the lid including respective inner walls (110, 210) confronting each other;
an audio playing module (400) provided in the casing which includes a phone jack (410) located on the inner wall of the casing;
an earphone (500) including an electrical plug (510) fixed inside the lid, the plug having an electrical connector (511) projecting from the inner wall of the lid and aligned with the phone jack for insertion into the phone jack upon the lid closing the casing;
**characterised in that** the waterproof audio player includes a securing member (300) extending substantially parallel to the electrical connector and which extends through the lid and engages with a part of the casing to thereby secure the lid closing the casing;
the lid having a central axis along which the securing member extends;
and the securing member comprising a screw or bolt (300) and the part of the casing comprises a nut (310).

2. The waterproof audio player as claimed in claim 1, **characterized in that** at least one of the casing and the lid includes resilient material (120) around its inner wall for sealing engagement with the inner wall of the other of the casing and the lid.

3. The waterproof audio player as claimed in claim 1 or claim 2, **characterized in that** the earphone includes an electric cable (520) connected to the plug and extending out from inside the lid, with a seal (211) provided between the cable and the lid.

4. The waterproof audio player as claimed in claim 3, **characterized in that** the seal comprises glue (211).

5. The waterproof audio player as claimed in any preceding claim, **characterized in that** the electrical plug (510) includes a base (512) having a first end from which the electrical connector projects through the inner wall of the lid and an opposite second end located by an internal fixture of the lid.

6. The waterproof audio player as claimed in any preceding claim, **characterized in that** the audio playing module includes an input port (440) provided on the inner wall of the casing.

7. The waterproof audio player as claimed in claim 6, **characterized in that** the input port comprises a USB socket (440).

8. The waterproof audio player as claimed in any preceding claim, **characterized in that** the lid is detachable from the casing.

9. The waterproof audio player as claimed in any preceding claim, **characterized in that** the audio player module comprises an MP3 playing module (400).

## Patentansprüche

1. Wasserdichtes Audiospielgerät, umfassend:
einen Körper mit einem Gehäuse (100) und einem Deckel (200), der das Gehäuse abdichtend verschließt, wobei das Gehäuse und der Deckel jeweils Innenwände (110, 210) enthalten, die sich gegenüberliegen;
ein im Gehäuse bereitgestelltes Audiospielmodul (400), das eine Telefonbuchse (410) enthält, die auf der Innenwand des Gehäuses angeordnet ist;
einen Kopfhörer (500) mit einem Elektrostecker (510), der im Inneren des Deckels befestigt ist, wobei der Stecker einen Elektroverbinder (511) hat, der von der Innenwand des Deckels herausragt und mit der Telefonbuchse so ausgerichtet ist, dass er sich in die Telefonbuchse einfügt, wenn der Deckel das Gehäuse verschließt;
**dadurch gekennzeichnet, dass** der wasserdichte Audiospieler ein Sicherungsglied (300) enthält, das im Wesentlichen parallel zum Elektroverbinder verläuft und durch den Deckel verläuft und mit einem Teil des Gehäuses in Eingriff kommt, um **dadurch** das Verschließen des Gehäuses durch den Deckel zu sichern;
wobei das Sicherungsglied entlang einer Zentralachse des Deckels verläuft;
und das Sicherheitsglied eine Schraube oder einen Bolzen (300) umfasst und der Teil des Gehäuses eine Mutter (310) umfasst.

2. Wasserdichtes Audiospielgerät nach Anspruch 1, **dadurch gekennzeichnet, dass** von Gehäuse und Deckel mindestens eins elastisches Material (120) um seine Innenwand herum zum abdichtenden Eingriff mit der Innenwand des Gehäuses bzw. des Deckels enthält.

3. Wasserdichtes Audiospielgerät nach Anspruch 1 oder Anspruch 2, **dadurch gekennzeichnet, dass** der Kopfhörer ein Elektrokabel (520) enthält, das mit dem Stecker verbunden ist und von der Innenseite des Deckels nach außen verläuft, wobei eine Dichtung (211) zwischen dem Kabel und dem Deckel bereitgestellt ist.

4. Wasserdichtes Audiospielgerät nach Anspruch 3, **dadurch gekennzeichnet, dass** die Dichtung Klebstoff (211) umfasst.

5. Wasserdichtes Audiospielgerät nach einem der vorgehenden Ansprüche, **dadurch gekennzeichnet, dass** der Elektrostecker (510) einen Sockel (512) mit einem ersten Ende enthält, aus dem der Elektroverbinder durch die Innenwand des Deckels herausragt, und mit einem gegenüberliegenden zweiten Ende, das durch eine Innenbefestigung des Deckels positioniert ist.

6. Wasserdichtes Audiospielgerät nach einem der vorgehenden Ansprüche, **dadurch gekennzeichnet, dass** das Audiospielmodul einen Eingangsport (440) enthält, der an der Innenwand des Gehäuses bereitgestellt ist.

7. Wasserdichtes Audiospielgerät nach Anspruch 6, **dadurch gekennzeichnet, dass** der Eingangsport eine USB-Buchse (440) umfasst.

8. Wasserdichtes Audiospielgerät nach einem der vorgehenden Ansprüche, **dadurch gekennzeichnet, dass** der Deckel vom Gehäuse abnehmbar ist.

9. Wasserdichtes Audiospielgerät nach einem der vorgehenden Ansprüche, **dadurch gekennzeichnet, dass** das Audiospielermodul ein MP3-Spielmodul (400) umfasst.

## Revendications

1. Lecteur audio étanche à l'eau comprenant :
un corps comportant un boîtier (100) et un couvercle (200) fermant le boîtier d'une manière étanche, le boîtier et le couvercle comprenant des parois intérieures (110, 210) respectives se faisant face ;
un module de lecture audio (400) prévu dans le boîtier, qui comprend une prise TRS (410) située sur la paroi intérieure du boîtier ;
un écouteur (500) comprenant une prise électrique (510) fixée à l'intérieur du couvercle, la prise comportant un connecteur électrique (511) faisant saillie de la paroi intérieure du couvercle et aligné avec la prise TRS pour une insertion dans la prise TRS lorsque le couvercle ferme le boîtier ;
**caractérisé en ce que** le lecteur audio étanche à l'eau comprend un élément de fixation (300) s'étendant sensiblement parallèlement au connecteur électrique et qui s'étend à travers le couvercle et vient en prise avec une partie du boîtier pour fixer de ce fait le couvercle fermant le boîtier ;
le couvercle comportant un axe central le long duquel l'élément de fixation s'étend ;
et l'élément de fixation comprenant une vis ou un boulon (300) et la partie du boîtier comprend un écrou (310).

2. Lecteur audio étanche à l'eau selon la revendication 1, **caractérisé en ce qu'**au moins l'un du boîtier et du couvercle comprend un matériau élastique (120) autour de sa paroi intérieure pour une mise en prise étanche avec la paroi intérieure de l'autre du boîtier et du couvercle.

3. Lecteur audio étanche à l'eau selon la revendication 1 ou la revendication 2, **caractérisé en ce que** l'écouteur comprend un câble électrique (520) connecté à la prise et s'étendant vers l'extérieur à partir de l'intérieur du couvercle, un joint (211) étant prévu entre le câble et le couvercle.

4. Lecteur audio étanche à l'eau selon la revendication 3, **caractérisé en ce que** le joint comprend de la colle (211).

5. Lecteur audio étanche à l'eau selon l'une quelconque des revendications précédentes, **caractérisé en ce que** la prise électrique (510) comprend une base (512) ayant une première extrémité de laquelle le connecteur électrique se projette à travers la paroi intérieure du couvercle et une deuxième extrémité opposée située près d'une fixation interne du couvercle.

6. Lecteur audio étanche à l'eau selon l'une quelconque des revendications précédentes, **caractérisé en ce que** le module de lecture audio comprend un port d'entrée (440) prévu sur la paroi intérieure du boîtier.

7. Lecteur audio étanche à l'eau selon la revendication 6, **caractérisé en ce que** le port d'entrée comprend une embase USB (440).

8. Lecteur audio étanche à l'eau selon l'une quelconque des revendications précédentes, **caractérisé en ce que** le couvercle peut être détaché du boîtier.

9. Lecteur audio étanche à l'eau selon l'une quelconque des revendications précédentes, **caractérisé en ce que** le module de lecteur audio comprend un module de lecture MP3 (400).
